# EUROPEAN PATENT APPLICATION

(11) **EP 4 213 228 A1**
(43) Date of publication of application: **19.07.2023**
(21) Application number: 21879713.2
(22) Date of filing: 27.07.2021
(51) Int. Cl.: H01L 33/22, H01L 33/30, H01L 33/36

(54) **INFRARED LED ELEMENT**

(30) Priority: 15.10.2020 JP 2020173992
(71) Applicant: Ushio Denki Kabushiki Kaisha, Tokyo 100-8150 (JP)
(72) Inventor: ISHIHARA, Kuniaki, Tokyo 100-8150 (JP)
(74) Representative: Tomerius, Isabel
(86) International application number: PCT/JP2021/027664
(87) International publication number: WO 2022/079971

(57) **Abstract**

Provided is an infrared LED element that has an emission wavelength of 1000 nm or more and exhibits high light extraction efficiency while being allowed to be manufactured through a simple process. The infrared LED element has a peak wavelength in a range from 1000 nm to 2000 nm inclusive and includes: an InP substrate that has a semi-insulating property; a first semiconductor layer of a conduction type that is a p-type or an n-type, the first semiconductor layer being formed on top of the InP substrate; an active layer formed on top of the first semiconductor layer; a second semiconductor layer of a conduction type different from the conduction type of the first semiconductor layer, the second semiconductor layer being formed on top of the active layer; a first electrode formed on top of the first semiconductor layer, the first electrode being in an area in which the active layer is not formed; and a second electrode formed on top of the second semiconductor layer, the second electrode being disposed at a place apart from the first electrode in a direction parallel to a surface of the InP substrate.

## Description

### TECHNICAL FIELD

The present invention relates to an infrared LED element, and particularly relates to an infrared LED element having an emission wavelength of 1000 nm or more.

### BACKGROUND ART

In recent years, semiconductor light emitting elements having an emission wavelength in an infrared region of wavelengths of 1000 nm or more have been used for a wide variety of applications such as surveillance or monitoring cameras, gas detectors, medical sensors, and industrial equipment.

A semiconductor light-emitting element having an emission wavelength of 1000 nm or more is generally manufactured through the following procedure. A semiconductor layer of a first conduction type, an active layer (sometimes referred to as a "luminous layer"), and a semiconductor layer of a second conduction type are epitaxially grown in sequence on an indium phosphide (InP) substrate that acts as a growth substrate, and then an electrode for current injection is formed on the semiconductor wafer. After that, the semiconductor wafer is cut into a chip-shaped element.

Previously, in terms of a semiconductor light-emitting element having an emission wavelength of 1000 nm or more, semiconductor laser elements had been developed ahead of other semiconductor light-emitting elements. Meanwhile, the development of LED elements had not been advanced compared to laser elements because of very few applications of LED elements.

However, in recent years, in response to expansion of the range of applications, demand for infrared LED element products with increased efficiency has been growing. Patent Document 1 discloses an infrared LED element in which a wafer includes a crystal-grown LED structure on an InP substrate and electrodes formed on upper and lower surfaces of the wafer, for example. By applying a voltage across both of the electrodes and thereby injecting an electric current into an active layer, the infrared LED element emits light. Patent Documents 2 and 3 each disclose a structure in which a wafer includes a crystal-grown epitaxial semiconductor layer that has a LED structure on a growth substrate, for example. By joining the wafer to a conductive support substrate and then removing the growth substrate, the disclosed structure provides improved light extraction efficiency.

### PRIOR ART DOCUMENT

### PATENT DOCUMENTS

Patent Document 1: JP-A-4-282875
Patent Document 2: JP-A-2013-30606
Patent Document 3: JP-A-2012-129357

### SUMMARY OF THE INVENTION

### PROBLEMS TO BE SOLVED BY THE INVENTION

A case in which an LED element is provided by bonding a wafer and a support substrate separate from a growth substrate together, like the structure described in Patent Documents 2 and 3, requires a process for bonding the support substrate to the wafer. This makes production of the LED element complicated. Hence, in order to provide an LED element by a simple method, it is preferable to use the growth substrate as is, as shown, for example, in Patent Document 1.

However, in the case of the structure in Patent Document 1, the electrode is disposed on a surface (hereinafter referred to as a "back side") opposite to a side of the InP substrate on which an epitaxial layer is formed, and an electric current is required to flow into the InP substrate. Thus, the InP substrate is designed to exhibit conductivity by being doped with a dopant in high concentration.

In the case of the structure in Patent Document 1, infrared light emitted from the active layer is supposed to be extracted to a side remote from the InP substrate. However, infrared light emitted from the active layer also travels to a side adjacent to the InP substrate. If the InP substrate includes a dopant doped in high concentration, the infrared light is absorbed by free carriers present in the InP substrate. As a result, even if the electrode disposed on the back side of the InP substrate is made of a material that exhibits reflectivity, infrared light is absorbed inside the InP substrate whenever the infrared light passes through the InP substrate. This prevents the attainment of high light extraction efficiency.

InP-based infrared LED elements have been developed for optical communications until now. There has not been any strong incentive to improve the efficiency with which light is extracted from infrared LED elements because infrared LED elements are only required to guide infrared light to optical fibers to fulfill a communication function. This is also manifested in Patent Document 1, which has no suggestion about returning of the infrared light having traveled to the InP substrate side to the light extraction surface side.

Given the above problem, it is an object of the present invention to provide an infrared LED element that has an emission wavelength of 1000 nm or more and exhibits high light extraction efficiency while being allowed to be manufactured through a simple process.

### MEANS FOR SOLVING THE PROBLEMS

An infrared LED element according to the present invention has a peak wavelength in a range from 1000 nm to 2000 nm inclusive and includes: an indium phosphide (InP) substrate that has a semi-insulating property; a first semiconductor layer of a conduction type that is a p-type or an n-type, the first semiconductor layer being formed on top of the InP substrate; an active layer formed on top of the first semiconductor layer; a second semiconductor layer of a conduction type different from the conduction type of the first semiconductor layer, the second semiconductor layer being formed on top of the active layer; a first electrode formed on top of the first semiconductor layer, the first electrode being in an area in which the active layer is not formed; and a second electrode formed on top of the second semiconductor layer, the second electrode being disposed at a place apart from the first electrode in a direction parallel to a surface of the InP substrate.

In the present specification, a substrate having a "semi-insulating" property means that a dopant concentration of the substrate is less than 1 × 10¹⁷/cm³. At this time, the substrate has a resistivity of greater than or equal to 0.1 Ω·cm. On the other hand, a substrate being conductive means that by use of a dopant atom forming a donor or an acceptor, a dopant concentration of the substrate is greater than or equal to 1 × 10¹⁷/cm³. At this time, the substrate has a resistivity of less than 0.01 Ω·cm.

According to the infrared LED element described above, even when the InP substrate is energized, there is almost no free carrier because of being semi-insulating. As a result of this, when infrared light emitted from the active layer passes through the InP substrate, absorption of the infrared light by free carriers is less likely to occur inside the InP substrate. This feature will be described later with reference to Example.

For the infrared LED element, the first electrode and the second electrode are formed on the same side of the InP substrate. This eliminates the need for causing an electric current to flow to the active layer through the InP substrate at the time of energization. This makes it possible to inject an electric current into the active layer even when the InP substrate is semi-insulating.

In this way, for the infrared LED element, absorption of infrared light is reduced inside the InP substrate. Thus, of principal surfaces of the InP substrate, rather than the principal surface on a side on which the semiconductor layers are formed, the principal surface on an opposite side can be designated as a light extraction surface.

The infrared LED element has a structure in which the semiconductor layers are formed on top of the InP substrate. This allows the infrared LED elementto be manufactured without going through a process for bonding a support substrate separate from the InP substrate, which acts as a growth substrate, and the structure together. Thus, an infrared LED element with high light extraction efficiency can be provided by a simple method.

InP shows low mechanical stiffness and so if the substrate is reduced in thickness too much, a defect such as a crack or exfoliation may occur. Thus, a thickness of the InP substrate is preferably greater than or equal to 20 µm. However, since the substrate that is too thick causes the infrared LED element to increase in thickness (height) too much, the thickness is preferably less than or equal to 1000 µm.

Even when the thickness of the InP substrate is greater than or equal to 20 µm, the InP substrate is made of a semi-insulating material, and absorption of the infrared light, which is passing through the InP substrate, by free carriers is reduced. This provides high light extraction efficiency.

InP has a refractive index of around 3.2 to infrared light with a wavelength ranging from 1000 nm to 2000 nm and the refractive index is extremely higher than that of air (a refractive index of 1). Thus, part of the infrared light traveling to the InP substrate is totally reflected off an interface between the InP substrate and air and is returned to the InP substrate. As a result, it is assumed that the infrared light passes through the InP substrate a plurality of times until the infrared light is extracted out of the infrared LED element. Nevertheless, as described above, the infrared LED element includes the InP substrate, which exhibits a semi-insulating property, and thus provides high light extraction efficiency because absorption of the infrared light is reduced inside the InP substrate even if the infrared light is extracted out after passing through the InP substrate a plurality of times.

However, it is technically difficult to perfectly reduce the absorption of the infrared light to zero while the infrared light passes through the InP substrate a plurality of times. Hence, from the viewpoint of further improving the light extraction efficiency, the InP substrate may have asperities that are formed at least in a partial area on a side opposite to the side on which the first semiconductor layer is formed.

In one example, as a method of making an InP substrate semi-insulating, a method of doping the InP substrate with a transition metal capable of producing a deep-level trap can be used. A typical example of such a transition metal is Fe. The transition metal may be any metal, other than Fe, that is capable of producing a deep-level trap inside the InP substrate, and a metal such as W, may be used, for example.

The InP substrate may be undoped. Even if the obtained InP substrate is an undoped one, such a substrate is generally mixed with an unexpected impurity from a furnace wall or the like in a process of manufacturing a semiconductor crystal and is doped with impurities with a concentration approximately ranging from 1 × 10¹⁵/cm³ to 1 × 10¹⁶/cm³. Even such an undoped InP substrate exhibits a semi-insulating property and thus absorption of the infrared light is reduced.

The infrared LED element may include:
a first pad electrode formed on top of the first electrode; and
a second pad electrode formed on top of the second electrode,
wherein a surface opposite to the InP substrate of the first pad electrode and a surface opposite to the InP substrate of the second pad electrode are positioned at a substantially equal level.

The "substantially equal level" described herein means that a difference in level is reduced to such an extent that flip-chip mounting is allowed. Specifically, this means that the difference in level is reduced to 1 µm or less.

According to the infrared LED element described above, flip-chip mounting is allowed with the first pad electrode and the second pad electrode being connected, for example, to patterned electrodes formed on a submount. This eliminates the need for electrically connecting to the first pad electrode and the second pad electrode by wire bonding. This in turn eliminates the need for ensuring space for wire routing on the light extraction surface side and thus provides the infrared LED element that is low in profile. This further eliminates the need for forming a pad electrode on the light extraction surface side and thus contributes to an increase in light extraction area.

As described above, conventional InP-based infrared LED elements have been developed exclusively for optical communications. The efficiency with which infrared light is coupled to optical fibers has been an important factor. In other words, such infrared LED elements are preferably designed to perform point light emission as much as possible because surface light emission causes light to leak out through optical fibers. Thus, there has not been any strong incentive to enlarge an area from which light is extracted.

In contrast to this, according to the configuration described above, by designating one of the principal surfaces of the InP substrate as a light extraction surface and connecting each of the electrodes formed on the other principal surface opposite to the light extraction surface to an energization-use patterned electrode mounted on a stem, the infrared LED element of a flip-chip type is provided with an increased light extraction area and improved light extraction efficiency.

Moreover, in recent years, the range of applications for an infrared region of wavelengths of 1000 nm or more has been in an initial phase of expansion. In response to this, demand for small LED elements with high light emission efficiency has started to grow. For instance, in view of providing a wearable LED element, it is important not only to make a footprint smaller but also to reduce the thickness of the element (reduce a profile). The configuration described above eliminates the need for space for bonding wire routing and a ball for bonding wire connection and thus provides a low-profile LED element that is thin in overall thickness.

Meanwhile, if there is an incentive to provide flip-chip mounting of an infrared LED element that includes an InP substrate, it is usually assumed that the InP substrate is made of a conductive substrate. This is because a decrease in light emission efficiency caused by a concentrated flow of an electric current into a partial region is thought to be suppressed since the InP substrate being a conductive substrate allows an electric current to flow through the InP substrate when a voltage is applied across both electrodes.

However, if the InP substrate is made of a conductive substrate, infrared light is absorbed inside the InP substrate and high light extraction efficiency cannot be obtained. Even if the spread of electric currents in a surface direction is sacrificed a little, the absorption of infrared light inside the InP substrate has a marked influence from the viewpoint of light extraction efficiency. Hence, in the configuration described above, the InP substrate is semi-insulating to reduce the absorption of infrared light inside the InP substrate.

The second electrode may form a partial electrode that is formed on a partial area of the second semiconductor layer when viewed in a direction orthogonal to the surface of the InP substrate, and the infrared LED element may include:
an insulating layer formed on top of the second semiconductor layer, the insulating layer being in an area in which the second electrode is not formed and being made of a material that exhibits transparency to infrared light emitted from the active layer; and
a reflective electrode on top of the second electrode and the insulating layer, the reflective electrode being made of a material that has higher reflectance to the infrared light emitted from the active layer than the second electrode has.

The second electrode is required to be made of a material that can implement an ohmic contact with the second semiconductor layer. The second electrode can be, for example, made of a material such as Au/Zn/Au, AuZn, or AuBe. Such material exhibits relatively low reflectance to infrared light with a wavelength ranging from 1000 nm to 2000 nm.

In response to this, in the configuration described above, in addition to the second electrode being partially formed, the insulating layer that exhibits transparency to infrared light is formed in the area where the second electrode is not formed and the reflective electrode is included on top of these elements. This enables the infrared light that has been emitted from the active layer and that has traveled to the side remote from the InP substrate to be returned to the light extraction surface on the InP substrate side with high efficiency. This provides further increased light extraction efficiency.

The transmittance of the insulating layer to the infrared light is preferably 70% or higher, more preferably 80% or higher, and particularly preferably 90% or higher. Such an insulating layer can be made of a material such as SiO₂, SiN, or Al₂O₃.

The reflectance of the reflective electrode to the infrared light is preferably 70% or higher, more preferably 80% or higher, and particularly preferably 90% or higher. Such a reflective electrode can be made of a metallic material such as Ag, an Ag alloy, Au, Al, or Cu.

The first semiconductor layer may be made of a material having a refractive index difference from the InP substrate of less than 0.3.

According to the configuration, the infrared light that has been emitted from the active layer and that has traveled to the first semiconductor layer travels through the InP substrate and is extracted from the light extraction surface with total reflection being suppressed at an interface between the InP substrate and the first semiconductor layer. When the InP substrate is a growth substrate and the first semiconductor layer is made of a material (InP, GalnAsP, etc.) that can be lattice matched to the InP substrate, the difference in refractive index between the InP substrate and the first semiconductor layer can be reduced to less than 0.3, and total reflection can be suppressed at the interface between these elements.

For GaN-based ultraviolet LED elements, a sapphire substrate is used as a growth substrate for GaN-based semiconductor layers. In this case, the difference in refractive index at an interface between the sapphire substrate and the GaN-based semiconductor layer is greater than or equal to 0.8. Thus, in the case of a GaN-based ultraviolet LED element, if light is to be extracted from a side adjacent to the sapphire substrate, total reflection often takes place at the interface between the sapphire substrate and the GaN layer.

The infrared LED element may include a translucent layer on the surface of the InP substrate on the side opposite to the side on which the first semiconductor layer is formed, the translucent layer being made of a material that exhibits transparency to infrared light emitted from the active layer and that has a refractive index between a material of which the InP substrate is made and air.

According to the configuration, the translucent layer helps to decrease the difference in refractive index at an interface between the light extraction surface and the air as compared to a case in which the infrared light is directly extracted into the air from the InP substrate. This can decrease a proportion of the light totally reflected off into the InP substrate and further increase the light extraction efficiency.

### EFFECT OF THE INVENTION

According to the present invention, an infrared LED element is provided that has an emission wavelength of 1000 nm or more and that exhibits high light extraction efficiency while being allowed to be manufactured through a simple process.

### BRIEF DESCRIPTION OF THE DRAWINGS

Fig. 1 is a cross-sectional view schematically showing a structure of an embodiment of an infrared LED element according to the present invention.
Fig. 2A is a cross-sectional view showing the infrared LED element in Fig. 1 upside down from which illustration of some elements is omitted.
Fig. 2B is a schematic plan view of the infrared LED element shown in Fig. 2A, viewed from above.
Fig. 3A is a cross-sectional view for illustrating a step in a method of manufacturing an infrared LED element.
Fig. 3B is a cross-sectional view for illustrating a step in the method of manufacturing the infrared LED element.
Fig. 3C is a cross-sectional view for illustrating a step in the method of manufacturing the infrared LED element.
Fig. 3D is a cross-sectional view for illustrating a step in the method of manufacturing the infrared LED element.
Fig. 3E is a cross-sectional view for illustrating a step in the method of manufacturing the infrared LED element.
Fig. 3F is a cross-sectional view for illustrating a step in the method of manufacturing the infrared LED element.
Fig. 3G is a cross-sectional view for illustrating a step in the method of manufacturing the infrared LED element.
Fig. 3H is a cross-sectional view for illustrating a step in the method of manufacturing the infrared LED element.
Fig. 4 is a schematic cross-sectional view for illustrating a structure of a stem used for verification.
Fig. 5 shows results representing characteristics of optical output versus electric current of infrared LED elements of Example 1 and Comparative Example 1.

### MODE FOR CARRYING OUT THE INVENTION

An embodiment of an infrared LED element according to the present invention will be described with reference to the drawings. The drawings referred to below are schematic illustrations and the dimensional ratios in the drawings are not necessarily the same as the actual dimensional ratios. Furthermore, the dimensional ratios may not always be the same between the drawings.

In the present specification, the expression "a layer B is formed on top of a layer A" is intended to include a case in which the layer B is formed over a surface of the layer A through a thin film, as well as a case in which the layer B is formed directly on the surface of the layer A. The "thin film" referred to herein may indicate a layer having a film thickness of 50 nm or less and preferably a layer having a film thickness of 10 nm or less.

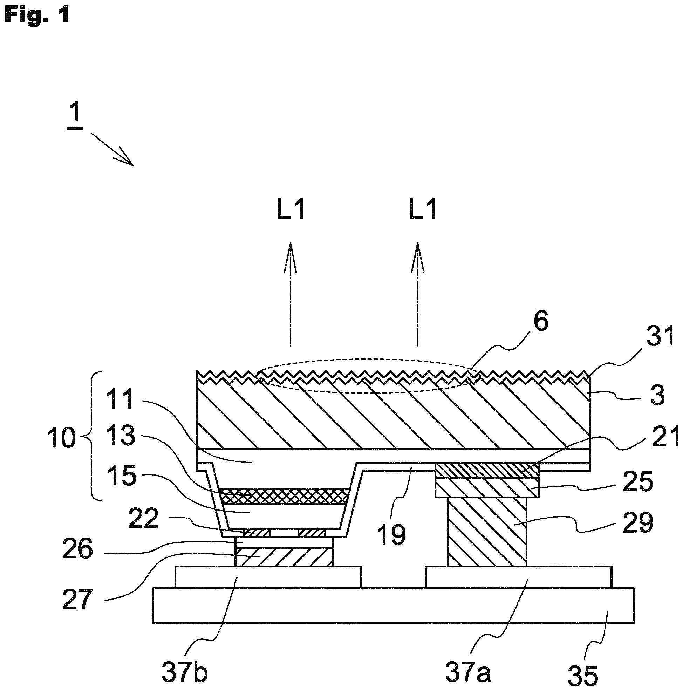

Fig. 1 is a cross-sectional view schematically showing a structure of an infrared LED element of the present embodiment. As shown in Fig. 1, an infrared LED element 1 includes an InP substrate 3 and a semiconductor layer 10 formed on top of the InP substrate 3. In one example, Fig. 1 illustrates a state in which the infrared LED element 1 is flip-chip mounted on a submount 35. In the example shown in Fig. 1, the infrared LED element 1 is fixed to the submount 35 through a patterned electrode 37a and a patterned electrode 37b.

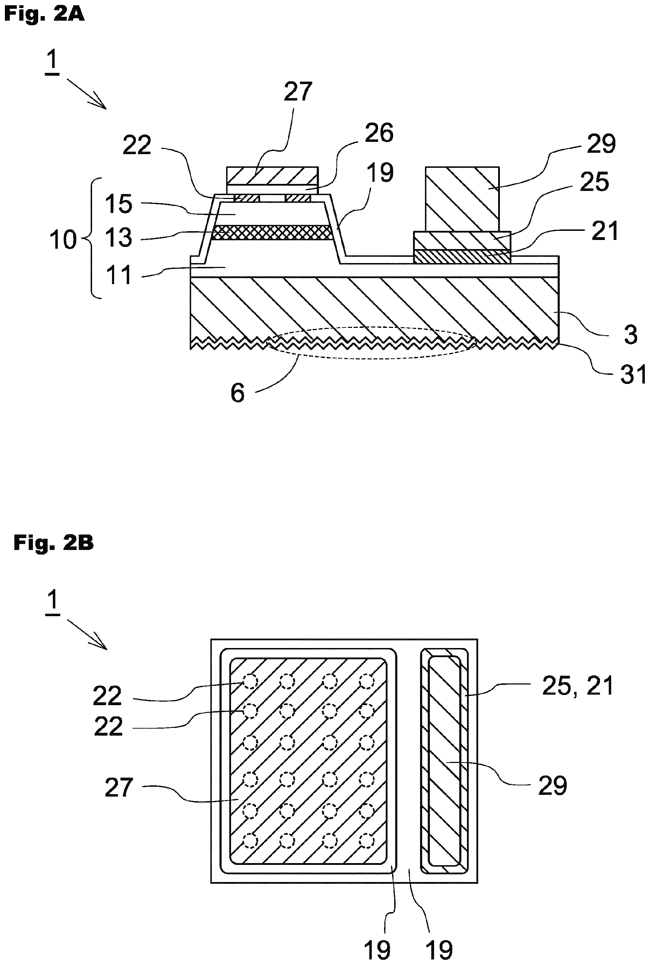

Fig. 2A is a cross-sectional view illustrating the infrared LED element in the state in Fig. 1 upside down for the convenience of explanation, from which illustration of the submount 35 and the patterned electrodes (37a, 37b) is omitted. Fig. 2B is a schematic drawing showing a plan view of the infrared LED element in a state in Fig. 2A, viewed from a side opposite the InP substrate 3.

In the infrared LED element 1 shown in Fig. 1, infrared light L1 generated in the semiconductor layer 10 (more specifically, in an active layer 13 described later) is extracted from a side opposite to the submount 35, i.e., the InP substrate 3 side. The infrared light L1 is light having a peak wavelength ranging from 1000 nm to 2000 nm inclusive.

### [Element structure]

A structure of the infrared LED element 1 will now be described in detail.

### (InP substrate 3)

The infrared LED element 1 includes the InP substrate 3. As described later in a section for an explanation of a method of manufacturing, the InP substrate 3 is also used as a growth substrate for causing the semiconductor layer 10 to grow. The InP substrate 3 exhibits a semi-insulating property and has a resistivity of greater than or equal to 1×10⁶ Ω·cm and a dopant concentration of less than 1 × 10¹⁷/cm³.

In the present embodiment, the InP substrate 3 is doped with Fe with a dopant concentration in a range of 1 × 10¹⁶/cm³ or greater and less than 1 × 10¹⁷/cm³. Fe is a type of a transition metal that produces a deep-level trap inside the InP. The InP substrate 3 exhibits a semi-insulating property by being extremely lowly doped with such a metal. A metal such as W, other than Fe, may be used as such a transition metal that produces a deep-level trap.

The InP substrate 3 may be an undoped substrate. Even an undoped substrate is inevitably mixed with an impurity during growth of the substrate and is doped with impurities with a dopant concentration of less than 1 × 10¹⁷/cm³.

A thickness of the InP substrate 3 is preferably from 20 µm to 1000 µm inclusive and more preferably from 50 µm to 700 µm inclusive.

### (Semiconductor layer 10)

The infrared LED element 1 includes the semiconductor layer 10 formed on top of the InP substrate 3. The semiconductor layer 10 is a laminate made up of a plurality of layers. Specifically, the semiconductor layer 10 includes a first semiconductor layer 11, the active layer 13, and a second semiconductor layer 15.

The first semiconductor layer 11 is formed on an upper surface of the InP substrate 3. In the present embodiment, the first semiconductor layer 11 is made of n-type InP. A thickness of the first semiconductor layer 11 is not limited, but ranges from 1000 nm to 20000 nm inclusive, for example, and preferably ranges from 3000 nm to 10000 nm inclusive. A concentration of a dopant in the first semiconductor layer 11 preferably ranges from 1 × 10¹⁷/cm³ to 5 × 10¹⁸/cm³ inclusive and more preferably ranges from 5 × 10¹⁷/cm³to 4 × 10¹⁸/cm³ inclusive. An n-type dopant material included in the first semiconductor layer 11 can be a substance such as Sn, Si, S, Ge, or Se. The dopant material is particularly preferably Si.

As shown in Figs. 1 and 2A, the first semiconductor layer 11 is formed substantially all over the surface of the InP substrate 3.

The active layer 13 is a semiconductor layer formed on top of the first semiconductor layer 11. More specifically, as shown in Figs. 1 and 2A, the active layer 13 is formed on top of a part of the first semiconductor layer 11.

A material for the active layer 13 is selected appropriately from ones that can generate light having a target wavelength and epitaxially grow by being lattice matched to the InP substrate 3. For instance, the active layer 13 may have a single-layer structure that includes GalnAsP, AlGaInAs, or InGaAs or may have a multiple quantum well (MQW) structure that includes a well layer made of GalnAsP, AlGaInAs, or InGaAs and a barrier layer made of GalnAsP, AlGaInAs, InGaAs, or InP that provides greater band gap energy than the well layer does.

A film thickness of the active layer 13 that has the single-layer structure ranges from 50 nm to 2000 nm inclusive and preferably ranges from 100 nm to 500 nm inclusive. When the active layer 13 has the MQW structure, the well layer and the barrier layer that each have a film thickness of 5 nm to 20 nm inclusive are laminated in a range of 2 cycles to 50 cycles inclusive.

The active layer 13 may be doped with an n-type or p-type dopant or may be undoped. If the active layer is doped with an n-type dopant, Si, for example, can be used as the dopant.

The second semiconductor layer 15 is formed on top of the active layer 13. In the present embodiment, the second semiconductor layer 15 is a p-type semiconductor layer and includes a p-type cladding layer and a p-type contact layer.

Of the second semiconductor layer 15, the p-type cladding layer is made of p-type InP. A thickness of the p-type cladding layer is not limited, but ranges from 1000 nm to 10000 nm inclusive, for example, and preferably ranges from 2000 nm to 5000 nm inclusive. A concentration of a p-type dopant in the p-type cladding layer, in a place apart from the active layer 13, preferably ranges from 1 × 10¹⁷/cm³to 3 × 10¹⁸/cm³ inclusive and more preferably ranges from 5 × 10¹⁷/cm³ to 3 × 10¹⁸/cm³ inclusive.

Of the second semiconductor layer 15, the p-type contact layer is made of p-type GalnAsP. A thickness of the p-type contact layer is not limited, but ranges from 10 nm to 1000 nm inclusive, for example, and preferably ranges from 50 nm to 500 nm inclusive. A concentration of a p-type dopant in the p-type contact layer preferably ranges from 5 × 10¹⁷/cm³ to 3 × 10¹⁹/cm³ inclusive and more preferably ranges from 1 ×10¹⁸/cm³ to 2 × 10¹⁹/cm³ inclusive.

A material such as Zn, Mg, or Be can be used as the p-type dopant contained in the p-type cladding layer and the p-type contact layer, which make up the second semiconductor layer 15. The material is preferably Zn or Mg and particularly preferably Zn.

A material for the first and the second semiconductor layers 11 and 15 is selected appropriately from ones that do not absorb the infrared light L1 generated in the active layer 13 and that can epitaxially grow by being lattice matched to the InP substrate 3. For instance, the first and the second semiconductor layers 11 and 15 can be made of a material, such as GalnAsP and AlGaInAs, as well as InP.

In the present embodiment, a case has been described in which the second semiconductor layer 15 has a laminated structure made up of a cladding layer and a contact layer. However, the present invention does not exclude a case where a material is shared by the cladding layer and the contact layer. Moreover, the present invention does not exclude a case where the first semiconductor layer 11 is a laminate made up of a cladding layer and a contact layer that are made of different materials.

### (First electrode 21)

As shown in Figs. 1 and 2A, the active layer 13 is formed on top of a partial area of the first semiconductor layer 11. The infrared LED element 1 includes a first electrode 21 that is formed on top of the first semiconductor layer 11 in an area where the active layer 13 is not formed.

An ohmic connection is formed between the first electrode 21 and the first semiconductor layer 11. In one example, the first electrode 21 is made of a material such as Au/Ge/Au, Au/Ge/Ni/Au, AuGe, or AuGeNi. The first electrode may include a plurality of kinds out of these materials. A thickness of the first electrode 21 is not limited, but ranges from 50 nm to 500 nm inclusive, for example, and preferably ranges from 100 nm to 300 nm inclusive.

### (Insulating layer 19)

As shown in Figs. 1 and 2A, the infrared LED element 1 includes an insulating layer 19 formed so as to partly cover a side wall and an upper surface of the semiconductor layer 10. The insulating layer 19 is made of a material that exhibits electrical insulation and that has high transparency to the infrared light L1. Transmittance of the insulating layer 19 to the infrared light L1 is preferably 70% or higher, more preferably 80% or higher, and particularly preferably 90% or higher. On condition that the peak wavelength of the infrared light L1 ranges from 1000 nm to 2000 nm inclusive, the insulating layer 19 can be made of a material such as SiO₂, SiN, or Al₂O₃.

A film thickness of the insulating layer 19 may be any value, but ranges from 50 nm to 5000 nm inclusive, for example, and preferably ranges from 100 nm to 1000 nm inclusive.

### (Second electrode 22)

As shown in Figs. 1 and 2A, the infrared LED element 1 includes a second electrode 22 formed on top of the second semiconductor layer 15. The second electrode 22 is disposed at a place apart from the first electrode 21 in a direction parallel to a surface of the InP substrate 3 (refer to Fig. 2B as well).

In the present embodiment, the second electrode 22 constitutes a partial electrode discretely disposed on top of a part of the second semiconductor layer 15. An example shown in Fig. 2B shows that a plurality of pieces of the second electrode 22 are discretely disposed on a plane when viewed from above. Actually, when the infrared LED element 1 is viewed from a side opposite to the InP substrate 3, the second electrode 22 is hidden behind a second pad electrode 27, which is described later, and is invisible, but in Fig. 2B, the second electrode 22 is illustrated by broken lines in terms of the facilitation of understanding.

The second electrode 22 is made of a material that allows an ohmic contact with the second semiconductor layer 15. In one example, the second electrode 22 is made of a material such as Au/Zn/Au, AuZn, or AuBe. The second electrode may include a plurality of kinds out of these materials. When the second semiconductor layer 15 includes the contact layer as described above, an ohmic contact is formed between the contact layer and the second electrode 22. A thickness of the second electrode 22 is not limited, but ranges from 50 nm to 500 nm inclusive, for example, and preferably ranges from 100 nm to 300 nm inclusive.

As shown in Figs. 1 and 2A, the insulating layer 19 is formed on top of the second semiconductor layer 15 and is in an area in which the pieces of the second electrode 22 are not formed.

### (Reflective electrode 26)

As shown in Figs. 1 and 2A, the infrared LED element 1 of the present embodiment includes a reflective electrode 26 on top of the second electrode 22. The reflective electrode 26 serves a function such that out of the infrared light L1 generated in the active layer 13, the infrared light L1 that has traveled to the second semiconductor layer 15 and passed through the insulating layer 19 is returned toward the InP substrate 3. The reflective electrode 26 is made of an electrically conductive material that exhibits high reflectance to the infrared light L1. The reflectance of the reflective electrode 26 to the infrared light L1 is preferably 70% or higher, more preferably 80% or higher, and particularly preferably 90% or higher. On condition that the peak wavelength of the infrared light L1 ranges from 1000 nm to 2000 nm inclusive, the reflective electrode 26 can be made of a metallic material such as Ag, an Ag alloy, Au, Al, or Cu.

A thickness of the reflective electrode 26 is not particularly limited, but ranges from 10 nm to 2000 nm inclusive, for example, and preferably ranges from 100 nm to 1000 nm inclusive.

The second electrode 22 is required to implement an ohmic contact with the second semiconductor layer 15 and is thus made of a material that is readily rendered into an alloy together with the second semiconductor layer 15 (more specifically, the contact layer) to provide low contact resistance. Hence, as described above, the second electrode 22 adopts AuZn, AuBe, or Au/Zn/Au layer structure, etc. However, these materials exhibit relatively low reflectance to the infrared light L1. As a result, out of the infrared light L1 that has been generated in the active layer 13 and that has traveled to the second semiconductor layer 15, a proportion of the infrared light L1 to be absorbed by the second electrode 22 increases if the second electrode 22 is formed on an entire surface of the second semiconductor layer 15.

On the other hand, in the infrared LED element 1 of the present embodiment, as described above, the pieces of the second electrode 22 are discretely disposed on top of the second semiconductor layer 15. At the same time, the insulating layer 19, which is made of a material that has high transparency to the infrared light L1, is formed on top of the second semiconductor layer 15 and is in an area in which the pieces of the second electrode 22 are not formed. On top of the insulating layer 19, the reflective electrode 26, which is made of a material that has higher reflectance to the infrared light L1 than the second electrode 22 does, is formed. Consequently, part of the infrared light L1 that has been generated in the active layer 13 and that has traveled to the second semiconductor layer 15 is not absorbed by the second electrode 22 but travels through the insulating layer 19 and is incident on the reflective electrode 26. After that, the part of the infrared light is reflected off the reflective electrode 26 and is guided toward the InP substrate 3. This provides increased light extraction efficiency. The reflective electrode 26 does not come into contact with the second semiconductor layer 15 and thus does not need to be made of a material that can implement an ohmic contact with the second semiconductor layer 15. Hence, from metallic materials that exhibit higher reflectance than that of the second electrode 22, a material can be selected and used. Specifically, the reflective electrode 26 can be made of a material such as Al, Au, or Al/Au.

The reflective electrode 26 may be integrated with the second pad electrode 27, which is described later.

### (First pad electrode 25, second pad electrode 27)

As shown in Figs. 1 to 2B, the infrared LED element 1 includes a first pad electrode 25 formed on top of the first electrode 21 and the second pad electrode 27 formed on top of the second electrode 22. Although the example in Figs. 1 and 2A illustrates a structure in which the second pad electrode 27 is formed on top of the reflective electrode 26, the second pad electrode 27 may double as the reflective electrode 26 if the second pad electrode 27 exhibits high reflectance to the infrared light L1.

The first pad electrode 25 and the second pad electrode 27 each have an area that is formed to connect with a bonding wire. The first pad electrode 25 and the second pad electrode 27 are, for example, made of a material such as Ti/Au or Ti/Pt/Au. A thickness of each of the first pad electrode 25 and the second pad electrode 27 is not particularly limited, but ranges from 500 nm to 5000 nm inclusive, for example, and preferably ranges from 1000 nm to 4000 nm inclusive.

### (Height adjustment electrode 29)

As shown in Figs. 1 to 2B, the infrared LED element 1 includes a height adjustment electrode 29 formed on top of the first pad electrode 25. The height adjustment electrode 29 is disposed to mount the infrared LED element 1 in flip chip style as shown in Fig. 1. As shown in Figs. 1 and 2A, the first pad electrode 25 is formed at a place nearer to the InP substrate 3 than the second pad electrode 27 is. This causes a difference in level position between the first pad electrode 25 and the second pad electrode 27. When the infrared LED element 1 is flip-chip mounted, as shown in Fig. 1, it is necessary to ensure an electrical connection between the patterned electrode 37a formed on the submount 35 and the first pad electrode 25 while forming an electrical connection between the patterned electrode 37b formed on the submount 35 and the second pad electrode 27.

With this in view, the height adjustment electrode 29 is formed to compensate for the difference in level between the first pad electrode 25 and the second pad electrode 27. A material for the height adjustment electrode 29 is not limited. The height adjustment electrode can be, for example, made of a material such as an Au plating, a Ni plating, or a Cu plating, or may be made of a combination of a plurality of kinds out of these materials. However, from the viewpoint of oxidation resistance, it is preferable to be formed by Au plating at least in an area near the surface of the height adjustment electrode 29, in the thickness range of several tens to several hundreds nm from the surface.

### (Asperities 6, translucent layer 31)

In the infrared LED element 1 of the present embodiment, asperities 6 are formed on a light-extraction side surface of the InP substrate 3. Arithmetic average roughness Ra of the asperities 6 is preferably 10 nm or greater and more preferably 100 nm or greater. With such asperities 6 formed, a proportion of the infrared light L1 totally reflected off the surface of the InP substrate 3 after being generated in the active layer 13 and traveling to the InP substrate 3 decreases, and the light extraction efficiency improves.

Further, the infrared LED element 1 of the present embodiment includes a translucent layer 31 on a principal surface of the InP substrate 3 that is opposite to the side on which the semiconductor layer 10 is formed. The translucent layer is made of a material that has high transmittance to the infrared light L1. The material for the translucent layer 31 is selected from ones that have a transmittance of 80% or higher to the infrared light L1 and a refractive index between refractive indexes of InP and the air. Specifically, the translucent layer 31 can be made of a material such as SiOₓ, SiON, SiNₓ, TiOₓ, or MgOₓ, or may be made of a combination of a plurality of kinds out of these materials.

Since the infrared LED element 1 includes the translucent layer 31, which has a refractive index between the refractive indexes of the air and InP, the proportion of the infrared light L1 totally reflected off the surface of the InP substrate 3 further decreases and the light extraction efficiency further improves. In particular, the refractive index of InP to the infrared light L1 with a wavelength of 1000 nm to 2000 nm is around 3.2, and there is a large difference between the InP refractive index and the air refractive index (= 1). Hence, with the translucent layer 31 included on top of the InP substrate 3, the infrared LED element provides substantially increased light extraction efficiency.

According to the infrared LED element 1 of the present embodiment, the InP substrate 3 is made of a semi-insulating material and thus the light extraction efficiency increases. This point will be described later with reference to results of verification.

### [Method of manufacturing]

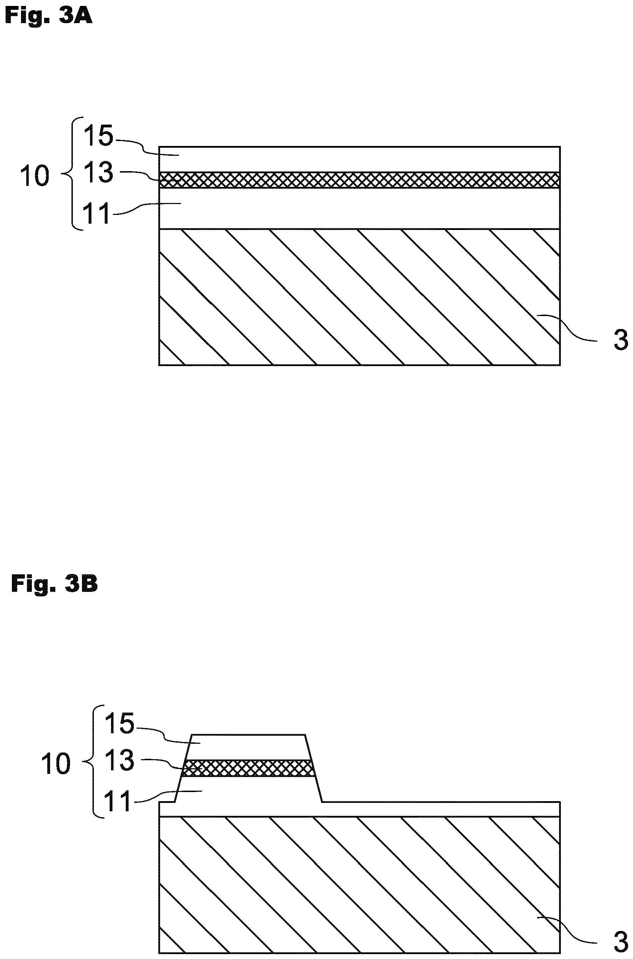

With reference to Figs. 3A to 3H, an example of a method of manufacturing the infrared LED element 1 will be described. Figs. 3A to 3H are each a cross-sectional view showing a step in a manufacturing process.

### (Step S1)

The InP substrate 3 that exhibits a semi-insulating property is prepared. As described above, the InP substrate 3 may be a substrate that is doped with Fe or another transition metal producing a deep-level trap such that the dopant concentration is in a range of 1 × 10¹⁶/cm³ or greater and less than 1 × 10¹⁷/cm³, or an undoped substrate may be used. In one example, an Fe-doped InP substrate 3 that has a size of two inches and a thickness of 370 µm can be used.

### (Step S2)

As shown in Fig. 3A, the semi-insulating InP substrate 3 is conveyed into a metal organic chemical vapor deposition (MOCVD) apparatus, and the first semiconductor layer 11, the active layer 13, and the second semiconductor layer 15 are epitaxially grown in sequence on the InP substrate 3 to form the semiconductor layer 10. In step S2, a type and a flow rate of a material gas, treatment time, environmental temperature, and other conditions are appropriately adjusted depending on the material for the grown layer and the film thickness. Examples of the materials for the layers of the semiconductor layer 10 are as described above.

### (Step S3)

The epitaxial wafer is taken out of the MOCVD apparatus, and as shown in Fig. 3B, the second semiconductor layer 15 and the active layer 13 inside a partial area are removed by etching to cause the first semiconductor layer 11 to be exposed. Specifically, this step is performed, for example, by the following procedure.

First, a mask layer (a SiO₂ layer in this example) is deposited in a predetermined film thickness on an upper surface of the second semiconductor layer 15, i.e., an outermost surface of the semiconductor layer 10, by a plasma-enhanced chemical vapor deposition (CVD) technique, and then a resist-made opening is formed using a photolithography technique. Next, by buffered hydrofluoric acid, the mask layer inside the resist-made opening is etched and removed, and then the resist is removed. The semiconductor layer 10 with the mask layer as a mask is etched by Cl₂ gas-based dry etching to remove the second semiconductor layer 15 and the active layer 13 inside a partial area as well as a part of the first semiconductor layer 11. After that, the remaining mask layer is removed using buffered hydrofluoric acid.

### (Step S4)

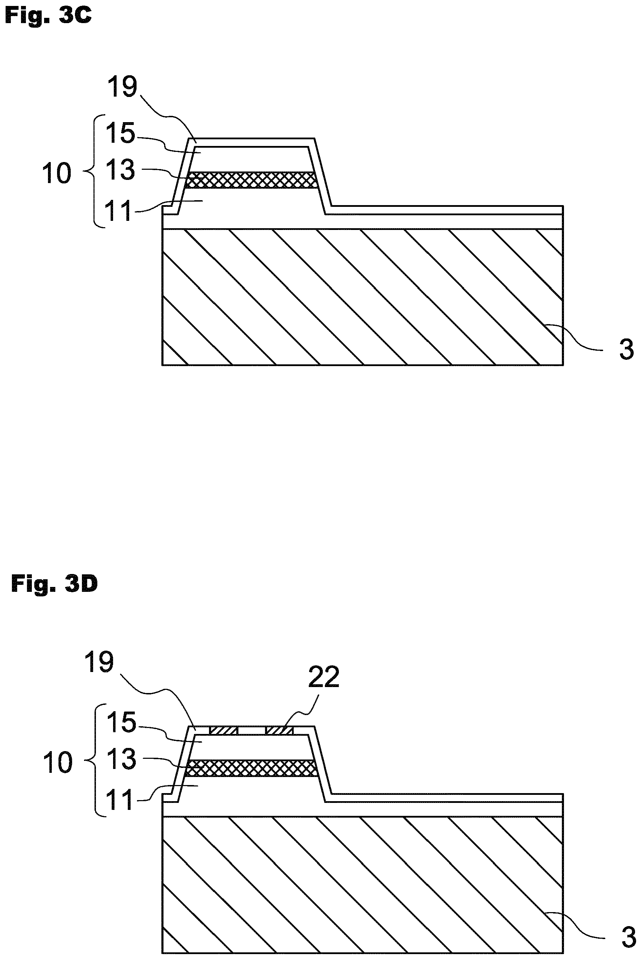

As shown in Fig. 3C, the insulating layer 19 is deposited on an entire surface of the semiconductor layer 10 by the plasma-enhanced CVD technique.

### (Step S5)

As shown in Fig. 3D, each piece of the second electrode 22 is formed on a partial area of the second semiconductor layer 15. Specifically, this step is performed, for example, by the following procedure.

First, a resist-made opening is formed at a particular place on the insulating layer 19 using the photolithography technique, and then the insulating layer 19 inside the resist-made opening is removed using buffered hydrofluoric acid. Next, a material film for the second electrode 22 is deposited using an electron beam (EB) vapor deposition apparatus, and then the resist is removed and the material film that is formed at a place outside an area in which the second electrode 22 is destined to be formed is removed by a lift-off process.

After that, alloy treatment (annealing treatment) is performed, for example, through a heating process at 450°C for 10 minutes to provide an ohmic contact between the second semiconductor layer 15 and the second electrode 22.

### (Step S6)

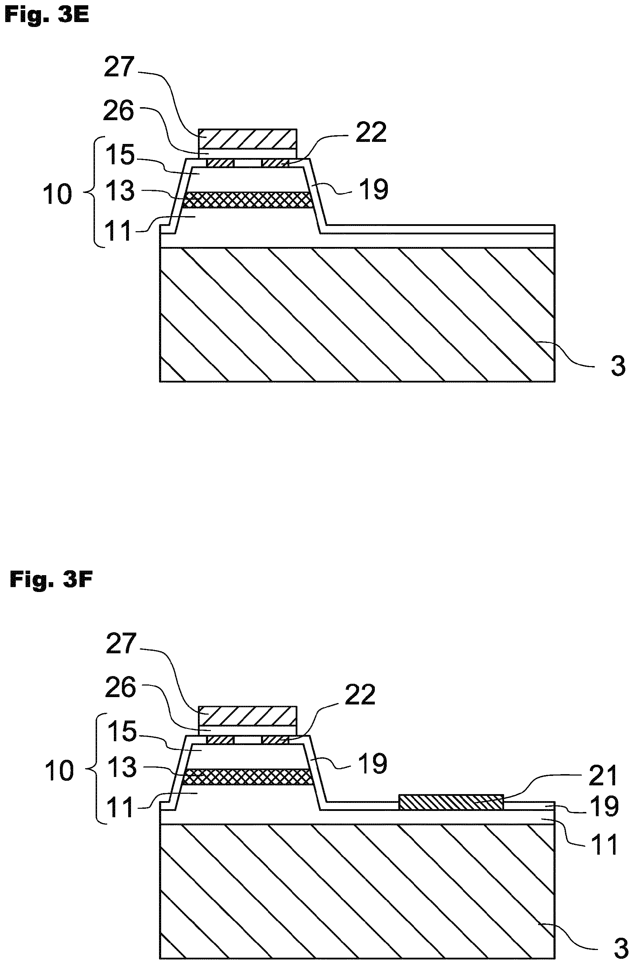

As shown in Fig. 3E, the reflective electrode 26 is formed on top of the second electrode 22, and further the second pad electrode 27 is formed on top of the reflective electrode 26. Specifically, this step is performed, for example, by the following procedure.

A resist-made opening is formed on top of the second electrode 22 using the photolithography technique, and then a material film for the reflective electrode 26 and a material film for the second pad electrode 27 are deposited using the EB vapor deposition apparatus. The reflective electrode 26 and the second pad electrode 27 may be formed continuously. By depositing, for example, a laminate of Al/Au/Ti/Pt/Au, a laminated structure made up of the reflective electrode 26 and the second pad electrode 27 is formed continuously.

### (Step S7)

As shown in Fig. 3F, the first electrode 21 is formed on top of the first semiconductor layer 11 and at a particular place in an area in which the active layer 13 is not formed. Specifically, this step is performed, for example, by the following procedure.

First, a resist-made opening is formed at a particular place on the insulating layer 19 using the photolithography technique, and then the insulating layer 19 inside the resist-made opening is removed using buffered hydrofluoric acid. Next, a material film for the first electrode 21 is deposited using the electron beam (EB) vapor deposition apparatus, and then the resist is removed and the material film that is formed at a place outside an area in which the first electrode 21 is destined to be formed is removed by a lift-off process.

After that, alloy treatment (annealing treatment) is performed, for example, through a heating process at 350 °C for 10 minutes to provide an ohmic contact between the first semiconductor layer 11 and the first electrode 21.

### (Step S8)

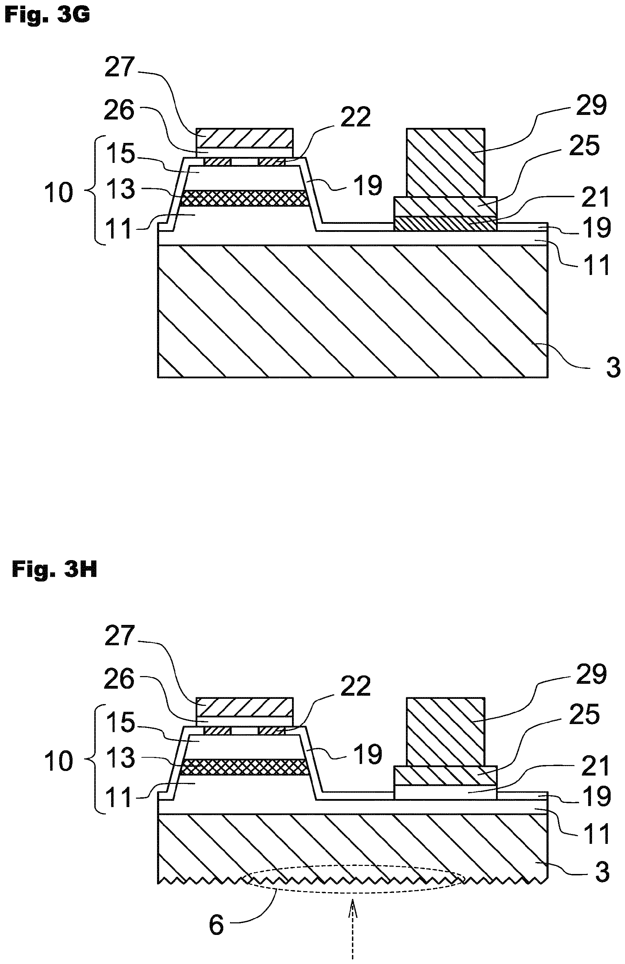

As shown in Fig. 3G, the first pad electrode 25 is formed on top of the first electrode 21, and further the height adjustment electrode 29 is formed on top of the first pad electrode 25. Specifically, this step is performed, for example, by the following procedure.

A resist-made opening is formed on top of the first electrode 21 using the photolithography technique, and then a material film for the first pad electrode 25 is deposited using the EB vapor deposition apparatus. For instance, a film of Ti/Pt/Au is deposited as the first pad electrode 25.

Next, a resist-made opening is formed on top of the first electrode 21 using the photolithography technique, and then the height adjustment electrode 29 made of an Au plate is grown on top of the first pad electrode 25 inside the resist-made opening using an electroless Au plating technique. As a result of this, the height adjustment electrode 29 and the second pad electrode 27 are adjusted to a substantially equal level. The height adjustment electrode 29 may be grown using an electrolytic plating technique or an EB vapor deposition technique.

### (Step S9)

As shown in Fig. 3H, the principal surface of the InP substrate 3, opposite the side on which the semiconductor layer 10 is formed, is thinned. Specifically, this step is performed, for example, by the following procedure.

With the surface of the InP substrate 3 on the side on which the semiconductor layer 10 is formed being fixed to a support through wax, the surface on the other side is ground by a single-side polisher using a slurry solution and colloidal silica until the InP substrate reaches a desired thickness (for example, 150 µm). After grinding, abrasive grains are removed by an alkaline cleaning solution, and then the InP substrate 3 is taken off the support and the wax is removed by cleaning.

Through this step S9, the asperities 6 are formed on the principal surface of the InP substrate 3 on the side opposite to the side on which the semiconductor layer 10 is formed. The arithmetic average roughness Ra of the asperities 6 is preferably 10 nm or greater and more preferably 100 nm or greater. In one example, the asperities 6 with an arithmetic average roughness Ra of 460 nm are formed in the InP substrate 3.

### (Step S10)

Next, as shown in Fig. 2A, using the plasma-enhanced CVD technique, the translucent layer 31 is deposited on the principal surface of the InP substrate 3 on which the asperities 6 are formed. Although Fig. 2A illustrates asperities that are formed on a surface of the translucent layer 31 to fit for a shape of the asperities 6 formed on the principal surface of the InP substrate 3, the surface of the translucent layer 31 may be flatter than that of the InP substrate 3.

### (Step S11)

Next, the InP substrate 3 is attached to a dicing tape, is made into a chip by blade dicing, and then, as shown in Fig. 1, is mounted on the submount 35. More specifically, the submount 35 with the patterned electrode 37a and the patterned electrode 37b formed on an upper surface thereof is prepared. The patterned electrode 37a and the height adjustment electrode 29 are bonded together and the patterned electrode 37b and the second pad electrode 27 are bonded together by ultrasonic waves. As a result of this, the flip-chip mounted infrared LED element 1 is manufactured.

### [Verification]

Infrared LED elements 1 were manufactured by a shared method of steps S1 to S11 described above except for different dopants for respective InP substrates 3, and I-L characteristics (electric current-optical output characteristics) were measured.

### (Example 1)

In Example 1, an infrared LED element 1 that includes the InP substrate 3 doped with Fe with a dopant concentration of 5 × 10¹⁶/cm³ was manufactured through steps S1 to S11. At this time, the InP substrate 3 of Example 1 had a resistivity of 2 × 10¹⁷ Ω·cm. In other words, the infrared LED element 1 of Example 1 includes the semi-insulating InP substrate 3. The resistivity of the InP substrate was measured by the van der Pauw method. The same method was used for Comparative Example 1 below. The resistivity may be measured using another known method such as the four-point probes contact method and eddy current method other than the van der Pauw method.

### (Comparative Example 1)

In Comparative Example 1, an infrared LED element 1 was manufactured by the same method as Example 1 except that an InP substrate doped with Sn with a dopant concentration of 3×10¹⁸/cm³ was used. At this time, the InP substrate of Comparative Example 1 had a resistivity of 7 × 10⁻⁴ Ω·cm. In other words, the infrared LED element of Comparative Example 1 includes the conductive InP substrate.

### (Measurement method)

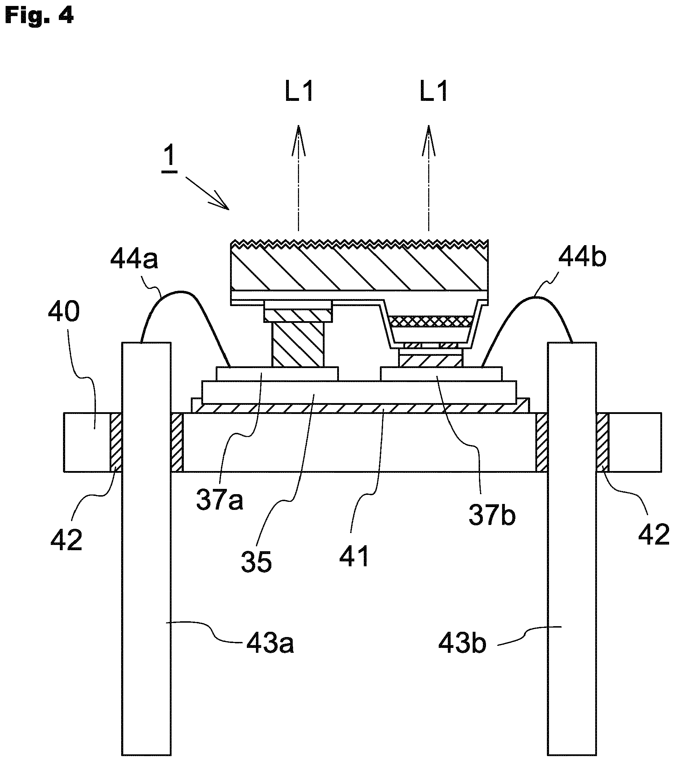

The elements of Example 1 and Comparative Example 1 were each mounted on a stem 40 as shown in Fig. 4, and electricity was supplied from a power source (not illustrated) to plot a relationship between the amount of electric current and optical output. The optical output was measured using an integrating sphere method based on an amount of infrared light L1 received by a light receiving sensor.

A specific structure of the stem 40 shown in Fig. 4 will be described. A pair of feeder pins (43a, 43b) are electrically insulated from each other by respective insulating members 42 and are inserted in the stem 40. The submount 35 of the infrared LED element 1 is fixed to an upper surface of the stem 40 by silver paste 41. The feeder pin 43a and the patterned electrode 37a are connected to each other by a bonding wire 44a, and the feeder pin 43b and the patterned electrode 37b are connected to each other by a bonding wire 44b.

### (Results)

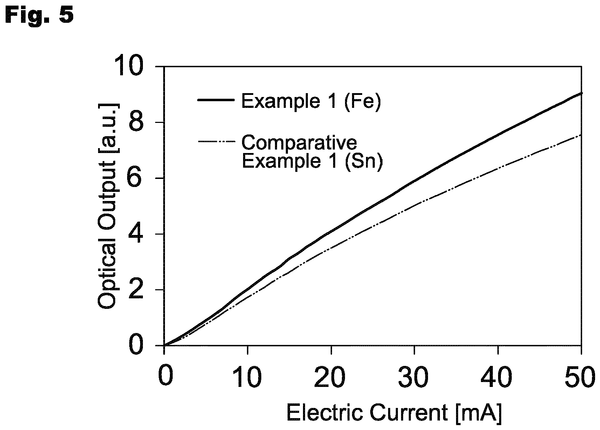

Fig. 5 is a graph showing the I-L characteristics of the elements of Example 1 and Comparative Example 1. In Fig. 5, the horizontal axis represents the amount of supplied electric current, and the vertical axis represents optical output. As shown in Fig. 5, it is found that the optical output of the infrared LED element 1 of Example 1 mounted on the semi-insulating InP substrate 3 is higher than that of the infrared LED element of Comparative Example 1 mounted on the conductive InP substrate.

For the infrared LED element of Comparative Example 1, which includes the conductive InP substrate, many free carriers are present in the InP substrate that is energized. Thus, it is surmised that the optical output is lower because the infrared light L1 that has been generated in the active layer 13 and that has traveled to the InP substrate is absorbed by the free carriers present in the InP substrate. On the other hand, for the infrared LED element 1 of Example 1, which includes the semi-insulating InP substrate 3, the amount of free carriers present in the InP substrate 3 that is energized is substantially decreased compared to Comparative Example 1. Thus, it is surmised that the optical output is higher than that of Comparative Example 1 because the absorption of the infrared light L1 passing through the InP substrate 3 is reduced.

### [Other embodiments]

Other embodiments will now be described.
<1 > In the embodiment above, with reference to Fig. 1, a case is described in which the infrared LED element 1 is flip-chip mounted. However, the infrared LED element 1 for which a mounting style (what is called face-up mounting) is adopted is also within the scope of the present invention. In the mounting style, the semiconductor layer 10 is energized with bonding wires that are connected to the first pad electrode 25 and the second pad electrode 27. In this case, the infrared LED element 1 is not necessarily required to include the height adjustment electrode 29 or the reflective electrode 26.
However, in the case of face-up mounting, the side adjacent to the electrodes (21, 22) is a light extraction surface and thus, the electrodes (21, 22) and the bonding wires cause the light extraction area to decrease and the infrared LED element 1 to increase in thickness compared to the case of flip-chip mounting. Hence, from the viewpoint of exhibiting increased light extraction efficiency and providing a low-profile element, the infrared LED element 1 destined to be flip-chip mounted, as shown in Fig. 1, is preferable.
<2> In the embodiment described above, the InP substrate 3 includes the asperities 6. In the present embodiment, however, whether or not the InP substrate 3 includes the asperities 6 is optional. However, from the viewpoint of improving the light extraction efficiency, the InP substrate 3 preferably includes the asperities 6.
Similarly, in the embodiment described above, the infrared LED element 1 includes the translucent layer 31 on the light extraction surface side of the InP substrate 3. In the present embodiment, however, whether or not the infrared LED element 1 includes the translucent layer 31 is optional. However, from the viewpoint of improving the light extraction efficiency, the infrared LED element 1 preferably includes the translucent layer 31.
   Moreover, in the embodiment described above, the second electrode 22 constitutes a partial electrode. In the present embodiment, however, whether or not the second electrode 22 is a partial electrode is optional. However, from the viewpoint of improving the light extraction efficiency, it is preferred that the second electrode 22 be a partial electrode and the infrared LED element 1 include the reflective electrode 26 on top of the second electrode 22.
<3> In the embodiment above, a case is described in which the first semiconductor layer 11 is of an n-type and the second semiconductor layer 15 is of a p-type. However, these conduction types may be reversed.
<4> Of the steps making up the method of manufacturing described above, some steps may be reordered. For instance, the order of step S6, which forms the second electrode 22, and step S7, which forms the first electrode 21, can be reversed. For instance, step S9 of thinning the InP substrate 3 can be preceded by the step of forming the electrodes (21, 22).

### DESCRIPTION OF REFERENCE SIGNS

- 1: Infrared LED element
- 3: InP substrate
- 6: Asperities
- 10: Semiconductor layer
- 11: First semiconductor layer
- 13: Active layer
- 15: Second semiconductor layer
- 19: Insulating layer
- 21: First electrode
- 22: Second electrode
- 25: First pad electrode
- 26: Reflective electrode
- 27: Second pad electrode
- 29: Height adjustment electrode
- 31: Translucent layer
- 35: Submount
- 37a: Patterned electrode
- 37b: Patterned electrode
- 40: Stem
- 41: Silver paste
- 42: Insulating member
- 43a: Feeder pin
- 43b: Feeder pin
- 44a: Bonding wire
- 44b: Bonding wire

## Claims

1. An infrared LED element having a peak wavelength in a range from 1000 nm to 2000 nm inclusive, the infrared LED element comprising:
an indium phosphide (InP) substrate that has a semi-insulating property;
a first semiconductor layer of a conduction type that is a p-type or an n-type, the first semiconductor layer being formed on top of the InP substrate;
an active layer formed on top of the first semiconductor layer;
a second semiconductor layer of a conduction type different from the conduction type of the first semiconductor layer, the second semiconductor layer being formed on top of the active layer;
a first electrode formed on top of the first semiconductor layer, the first electrode being in an area in which the active layer is not formed; and
a second electrode formed on top of the second semiconductor layer, the second electrode being disposed at a place apart from the first electrode in a direction parallel to a surface of the InP substrate.

2. The infrared LED element according to claim 1, wherein the InP substrate has asperities that are formed at least in a partial area on a side opposite to the side on which the first semiconductor layer is formed.

3. The infrared LED element according to either claim 1 or 2, wherein the InP substrate is doped with a transition metal capable of producing a deep-level trap.

4. The infrared LED element according to claim 3, wherein the InP substrate is doped with Fe.

5. The infrared LED element according to either claim 1 or 2, wherein the InP substrate is undoped.

6. The infrared LED element according to either claim 1 or 2, further comprising:
a first pad electrode formed on top of the first electrode; and
a second pad electrode formed on top of the second electrode,
wherein a surface opposite to the InP substrate of the first pad electrode and a surface opposite to the InP substrate of the second pad electrode are positioned at a substantially equal level.

7. The infrared LED element according to either claim 1 or 2, wherein the second electrode forms a partial electrode that is formed on a partial area of the second semiconductor layer when viewed in a direction orthogonal to the surface of the InP substrate, the infrared LED element further comprising:
an insulating layer formed on top of the second semiconductor layer, the insulating layer being in an area in which the second electrode is not formed and being made of a material that exhibits transparency to infrared light emitted from the active layer; and
a reflective electrode on top of the second electrode and the insulating layer, the reflective electrode being made of a material that has higher reflectance to the infrared light emitted from the active layer than the second electrode has.

8. The infrared LED element according to either claim 1 or 2, wherein the first semiconductor layer is made of a material having a refractive index difference from the InP substrate of less than 0.3.

9. The infrared LED element according to either claim 1 or 2, wherein a thickness of the InP substrate is greater than or equal to 20 µm.

10. The infrared LED element according to either claim 1 or 2, further comprising a translucent layer on the surface of the InP substrate on the side opposite to the side on which the first semiconductor layer is formed, the translucent layer being made of a material that exhibits transparency to infrared light emitted from the active layer and that has a refractive index between a material of which the InP substrate is made and air.
